# EUROPEAN PATENT APPLICATION

(11) **EP 0 853 373 A1**
(43) Date of publication of application: **15.07.1998**
(21) Application number: 97310151.2
(22) Date of filing: 16.12.1997
(51) Int. Cl.: H03D 7/14

(54) **Double balanced mixer**

(30) Priority: 11.01.1997 GB 9700484
(71) Applicant: PLESSEY SEMICONDUCTORS LIMITED, Swindon, Wiltshire SN2 2QW (GB)
(72) Inventor: Souetinov, Viatcheslav Igor, Swindon, Wiltshire, SN2 3QG (GB)
(74) Representative: Hoste, Colin Francis

(57) **Abstract**

Mixer circuit 500 comprises mixer core 491 and amplifier stage 590. Improved noise properties of amplifier stage 590 are a result of transistors 401 and 403 being connected in cascode and transistors 403 and 404 being base driven by a current source, formed by resistor 450 and a potential applied to terminal 440. Degeneration inductor 460 can be thought of as a noiseless component and thus gives mixer circuit 500 better noise properties than if a resistor had been used in its place. Transistors 403 and 404 act as a phase splitter, giving complementary current signals at their respective collector electrodes. Negative feedback is achieved at transistor 401 by the insertion of resistor 520 and capacitor 510. Mixer core 491 mixes the current signals from transistors 403, 404 with a local oscillator signal input at terminals 420, 421.

## Description

The invention relates to mixer circuits and in particular to mixer circuits having a single-ended input and a differential output.

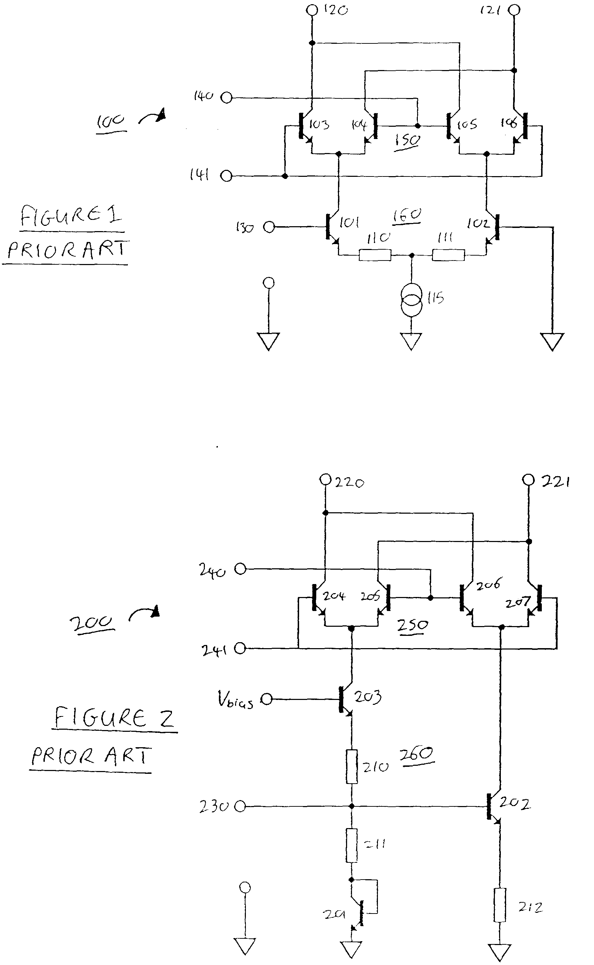

RF mixers are the key blocks of modern radio systems and their parameters determine the main characteristics of the system in which they are used. The most common mixer circuit configurations are those of the Gilbert cell and the Micromixer, shown in Figures 1 and 2 respectively.

Each of these mixer circuits receives at its input terminal a single-ended rf input signal and shows at its output a differential signal being the input signal first amplified and subsequently mixed with a signal from a local oscillator. Both of these circuits are easily implemented in IC form and are commonly used in mobile telephones and the like. However, mixers constructed using these circuit configurations exhibit poor noise properties. It is difficult also to design the Gilbert cell mixer circuit with a particular input impedance. This can be a drawback when impedance matching with a pre-amp stage is necessary.

The Gilbert cell circuit 100 of Figure 1 receives a single-ended input voltage signal at terminal 130 and a differential local oscillator voltage signal at terminals 140 and 141. Transistors 101, 102, resistors 110, 111 and current source 115 form a standard differential transconductance amplifier 160 whilst transistors 103-106 form a standard mixer core 150. A change in the input voltage at terminal 130 will cause an inverted and amplified current signal from the collector terminal of transistor 101. Current source 115 and resistors 110, 111 ensure that a complementary current signal will flow from the collector electrode of transistor 102. These current signals will be balanced if current source 115 is implemented as a constant current source.

Mixer core 150 receives a substantially sinusoidal local oscillator signal as a differential voltage signal on terminals 140, 141. When the voltage on terminal 140 is positive, the voltage on terminal 141 will be negative causing transistors 104 and 105 to be switched on and transistors 103 and 106 to be switched off. The collector current of transistor 101 will therefore be routed to output electrode 121 whilst the collector current of transistor 102 will be routed to output terminal 120. The collector currents of transistors 101, 102 will obviously be routed to the opposite output terminal 120, 121 when terminal 141 receives a higher voltage than terminal 140.

The poor noise properties of this mixer configuration are due largely to the thermal noise of resistors 110 and 111 which produce noise directly in the main current paths. Current source 115 will also introduce noise into the output signal, because it experiences quite large voltage swings across its input and output terminals. A significant amount of noise will appear at output terminals 120, 121 as a result of transistors 101, 102 having their base resistances in series.

The micromixer circuit 200 of Figure 2 receives a single-ended input signal at input terminal 230 and a differential local oscillator voltage signal at terminals 240 and 241. Transistors 201-203 and resistors 210-212 form a transconductance amplifier 260 whilst transistors 204-207 form a standard mixer core 250.

An increase in voltage at input terminal 230 will cause increased current to flow from the collector electrode of transistor 202 and a decreased current to flow from the collector of transistor 203. The circuit therefore acts as a transconductance amplifier having a single-ended input and a differential output. The output from amplifier 260 is taken from the collector electrodes of transistors 202 and 203, as a differential current signal, by mixer core 250.

Mixer core 250 functions in the same manner as mixer core 150 of the Figure 1 mixer circuit described above.

Micromixer circuits have very linear characteristics and large dynamic range at radio frequencies but, due to the large number of resistors used in the main current paths, have even worse noise properties than Gilbert cell circuits. There exists a need for a mixer circuit with improved noise properties.

In accordance with the present invention, there is provided a mixer circuit arrangement comprising first and second transistors having their control electrodes connected together and to a first current source, the first and second transistors outputting complementary current signals on their respective first main electrodes, in response to an input signal to a mixer core, the mixer core being arranged to mix the complementary current signals with an oscillatory signal to produce a differential output signal.

Embodiments of the present invention will now be described, by way of example only, with reference to the accompanying drawings, of which;
Figure 1 shows a prior art Gilbert cell mixer circuit;
Figure 2 shows a prior art Micromixer circuit;
Figure 3 shows a mixer circuit in accordance with the present invention, and
Figure 4 shows an improved mixer circuit in accordance with the present invention.

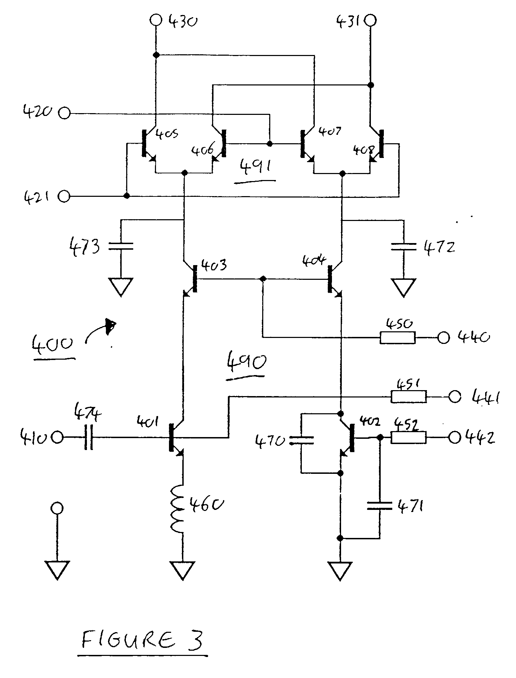

Referring to the drawings, Figure 3 shows a single-ended input, differential output, double-balanced mixer in accordance with the present invention.

Mixer circuit 400 is made up at amplifier stage 490 and mixer core 491. Mixer core 491 is substantially the same as the mixer core used in both the prior art Gilbert cell and Micromixer circuits. The noise properties of the Figure 3 mixer circuit are better than those of the aforementioned prior art mixer circuits because of an improved amplifier stage

490. Terminal 410 forms an input terminal and terminals 430, 431 form the mixer circuit output terminals. In operation, a local oscillator signal is applied to terminals 420, 421 as a differential voltage signal. Voltages are applied to terminals 440, 441 and 442 to form bias potentials with resistors 450, 451 and 452 respectively.

Amplifier stage 490 is actually made up of a transconductance amplifier, based around transistor 401 and inductor 460, and a phase-splitter, based around transistors 403 and 404. Transistor 402 simply provides a current bias for transistor 404.

Transistors 401 and 403 are connected in a cascode configuration whilst transistor 403 is also base-coupled to transistor 404. Degeneration inductor 460 is connected between the emitter electrode of transistor 401 and ground potential. Due to the complex value of the common emitter current gain of transistor 401 at radio frequencies, inductor 460 effects series negative feedback in the base-emitter circuit of transistor 401.

A voltage is applied as the input signal to terminal 410, which is connected to the base electrode of transistor 401. Transistor 401 functions as a transconductance amplifier, translating an input voltage to an output current which is fed to the emitter electrode of transistor 403.

Transistors 403 and 404 have complementary collector currents. Variations in the collector current at transistor 401 directly cause variations in the distribution of the substantially constant current flowing in resistor 450 between the base electrodes, and hence the collector electrodes of transistors 403 and 404. Resistor 450 will tend to have a high value to provide a reasonably constant current. Transistors 403 and 404 introduce a negligible level of noise into the circuit because they are driven by a current source, that of transistor 401. Simulation of the amplifier stage 490 of Figure 3 has found that its noise figure is no higher than that of a cascode circuit in isolation.

Biasing of transistor 403 is provided by transistor 401, resistor 451 and a potential applied to terminal 441. Transistor 404 is biased by transistor 402, resistor 452 and a potential applied to terminal 442. The independent biasing of transistors 403, 404 provides control over the balancing of the current signal output from each of their collector electrodes.

Cascode circuits per se are well known for their good noise properties. Referring to Figure 3, it can be seen that these good noise properties are achieved because transistor 403 prevents the collector of transistor 401 from swinging and thereby substantially eliminates the Miller effect.

Inductor 460 is a noiseless component which provides frequency independent degeneration over a particular frequency range. This range is dependent on the value of inductor 460 and the base-emitter resistance of transistor 401 at the desired frequency. The value of inductor 460 also affects the gain of amplifier stage 490 and its linearity. Although a resistor could be used in place of inductor 460, amplifier stage 490 has much more linear characteristics and better noise properties when inductor 460 is used.

Inductor 460 can be implemented, in whole or in part, with the parasitic inductance of IC packaging, bonding wires and/or connecting pins.

Transistors that are used in low noise applications are generally fabricated with large emitter areas. These transistors have a lower base-emitter resistance than a smaller area transistor and hence produce less noise.

Transistors 401, 403 and 404 are preferably implemented as large emitter area transistors and more preferably with transistor 401 having a larger area than transistors 403 and 404. The sizing of transistor 401 is particularly important because it determines a number of properties at the amplifier stage 490. A larger area transistor will have better noise properties because the input impedance of the transistor will be lower. However, a larger area transistor will also have higher parasitic capacitances, and hence leakage, and, because of a lower current density, a lower current gain β.

The size of the current flowing in transistor 401 affects its impedance and therefore the properties at amplifier stage 490. Operating transistor 401 with a low current will give it good noise properties but will also cause β to be lower than it would be for a higher operating current.

A trade-off needs to be made between noise figure and gain when choosing what transistor area and what bias current should be incorporated into a particular mixer circuit design.

At high frequencies, the behaviour of transistors 403 and 404 will change because of the parasitic capacitances present across both the base-emitter and base-collector junctions of these transistors 403, 404. Leakage will occur between the emitter and the base electrodes of transistor 403 causing unbalancing between transistors 403 and 404.

This can be compensated for by forming transistor 403 with a larger emitter area than that of transistor 404. This larger area transistor will have a lower current density and hence a lower β. This will cause extra current to flow in the base of transistor 403 to compensate for current lost in the parasitic capacitances.

The emitter areas of transistors 403 and 404 required to balance the output signals will depend on the frequency at which mixer circuit 400 is to be operated, because β is frequency dependent, and on the bias currents driving transistors 403 and 404.

Transistor 402 and resistor 452 form a dc current source for transistor 404 from a potential on terminal 442. Capacitors 470 and 471 are connected so as to ground any ac component of the current at the collector electrode of transistor 404.

Transistor 401 is biased by a bias potential formed by resistor 451 and a potential applied to terminal 441. Capacitor 474 serves as a dc blocking capacitor.

The operation of mixer core 491 will be known by a person skilled in the art. Put simply, it achieves switching of each differential output of amplifier stage 490 between the differential output terminals 430, 431 alternately and at a frequency equal to the frequency of a signal applied to terminals 420 and 421.

Capacitors 472, 473 serve as filters of the second harmonic at the local oscillator signal that would normally be generated at the inputs of the mixer core. This harmonic is generated because of the difference in the switching-on and switching-off delays of transistors 405-408 in mixer core 491. This harmonic would normally be mixed as well as the input signals by mixer core 491 and produce a parasitic signal at the local oscillator frequency at output terminals 430, 431. The values of capacitors 472, 473 have to be chosen as a trade off between the efficiency of filtering and the efficiency of the conversion of the signal input to mixer core 491.

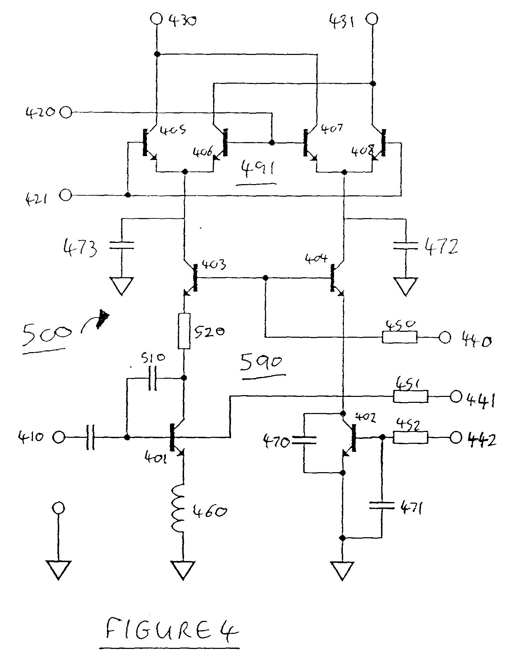

Figure 4 shows a further improved mixer circuit embodying the present invention. Components the same as those shown in Figure 3 have retained the same reference numerals.

Mixer circuit 500 has the same configuration of mixer core 491 as mixer circuit 400 of Figure 3. Amplifier stage 590 shows an improvement over Figure 3's amplifier stage 490 in that resistor 500 and capacitor 510 have been additionally incorporated to improve the linearity of mixer circuit 500 and to allow its input impedance to be tuned.

Resistor 520 is connected between transistors 401 and 403 to create a potential at the collector electrode of transistor 401 from the current flowing there. It need only be a small value resistor, say 20-30 Ω, so as not to introduce much noise into the outputs. Inductor 460 causes the voltage at the emitter electrode of transistor 401 to lead the voltage at the base electrode by 90°. Following on from this, the voltage at the collector electrode of transistor 401 will lag the voltage at the base electrode by 90°. Negative feedback is thus achievable by connecting capacitor 510 across the base and collector electrodes at transistor 401. This feedback will help to minimise any noise created by transistor 401 and improve the overall noise figure of mixer circuit 500. Mixer circuit 500 will also have improved linearity characteristics.

Capacitor 510 and resistor 520 will also have an effect on the input impedance of transistor 401, and hence mixer circuit 500, thereby allowing the impedance to be tuned in the design of the mixer circuit. It is even possible to make the input impedance purely real.

Although the embodiments have been described solely with regard to npn bipolar resistors, the invention is not restricted to such and could equally be effected with pnp bipolar transistors or with field effect transistors. The collector and emitter electrodes referred to will be interchangeable with emitter and collector, source and drain or drain and source electrodes as the first and second main electrodes of a pnp or a field effect transistor.

## Claims

1. A mixer circuit arrangement comprising first and second transistors having their control electrodes connected together and to a first current source, the first and second transistors outputting complementary current signals on their respective first main electrodes, in response to an input signal, to a mixer core, the mixer core being arranged to mix the complementary current signals with an oscillatory signal to produce a differential output signal.

2. A mixer circuit arrangement in accordance with Claim 1 in which a third transistor is arranged to receive the input signal at its control electrode and to have its first main electrode electrically connected to the second main electrode of the first transistor thereby to cause the first and second transistors to output complementary current signals in response to the input signal.

3. A mixer circuit arrangement in accordance with Claim 2 in which an inductor is connected between the second main electrode of the third transistor and ground potential.

4. A mixer circuit arrangement in accordance with Claim 3 in which the inductor is formed partly from at least one of bonding wires, connecting pins and IC packaging.

5. A mixer circuit arrangement in accordance with any preceding claim in which the second transistor is current biased.

6. A mixer circuit arrangement in accordance with Claim 5 in which the second transistor is current biased by a fourth transistor having its control electrode connected via a resistor to a first potential and its first main electrode connected to the second main electrode of the second transistor.

7. A mixer circuit arrangement in accordance with Claim 5 or Claim 6 in which the second main electrode of the second transistor is also ac grounded by a first capacitor.

8. A mixer circuit arrangement in accordance with any of Claims 2 - 7 in which the second main electrode of the first transistor and the first main electrode of the third transistor are connected together by a feedback resistor and the first main and control electrodes of the third transistor are connected together by a feedback capacitor.

9. A mixer circuit arrangement in accordance with any of Claims 2 - 8 in which the control electrode of the third transistor is connected to a second potential and receives the input signal via a dc blocking input capacitor.
